(19) Europäisches Patentamt
European Patent Office
Office européen des brevets

(11) **EP 4 636 417 A1**

(12) **EUROPEAN PATENT APPLICATION**

(43) Date of publication:
22.10.2025 Bulletin 2025/43

(21) Application number: 24170319.8

(22) Date of filing: 15.04.2024

(51) International Patent Classification (IPC):
**G01R 31/367** (2019.01)   **G01R 31/392** (2019.01)
**G06N 3/044** (2023.01)   **G06N 3/045** (2023.01)
**G06N 3/08** (2023.01)   **H01M 10/44** (2006.01)

(52) Cooperative Patent Classification (CPC):
**G01R 31/367; G01R 31/392; G06N 3/044;
G06N 3/045; G06N 3/08; H01M 10/44**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Ningbo Geely Automobile Research
& Development Co. Ltd.
Hangzhou Bay New District
Ningbo 315336 (CN)**

• **Zhejiang Geely Holding Group Co., Ltd.
Hangzhou, Zhejiang 310051 (CN)**

(72) Inventors:
• **ZHANG, Yizhou
43151 MÖLNDAL (SE)**
• **ZOU, Changfu
41326 GÖTEBORG (SE)**
• **WIK, Torsten
41672 GÖTEBORG (SE)**

(74) Representative: **Zacco Sweden AB
P.O. Box 5581
Löjtnantsgatan 21
114 85 Stockholm (SE)**

(54) **A METHOD FOR REAL-TIME ESTIMATION OF BATTERY ANODE POTENTIAL**

(57)   A method for real-time estimation of an anode potential of a battery (20) in connection with a battery charging event, comprising: obtaining at least one quantified State of Health [SoH] indicator of the battery (20) as output from a first machine-learning system (14); and feeding the obtained at least one quantified SoH indicator, together with battery charging data associated with the charging event, as input to a second machine-learning system (15), which provides an estimate of the anode potential of the battery (20) as output.

FIG.2

**Description**

TECHNICAL FIELD

The present disclosure relates to a method and system for real-time estimation of an anode potential of a battery in connection with a battery charging event.

The real-time estimation of an anode potential according to the disclosure can be implemented in any type of application having a battery that is fast charged, such as for example an electric vehicle, electric marine vessel, electric truck, electric bus, electric working vehicle, electric airplane or the like.

BACKGROUND

The faster charging speed of the lithium-ion battery and its longer lifetime is a known dilemma in the automotive industry. Pushing too hard on the battery charging speed will cause accelerated side reactions in the batteries. One of the most critical ones during charging is the onsite lithium plating, which will accelerate the degradation of the battery.

There is thus a need for an improved method for reducing the risk of accelerated degradation of the battery in connection with battery fast charging.

SUMMARY

An object of the present disclosure is to provide a method and system for enabling the previously mentioned problems to be avoided. This object is at least partly achieved by the features of the independent claims. The dependent claims contain further developments of said method and system.

According to a first aspect of the present disclosure, there is provided a method for real-time estimation of an anode potential of a battery in connection with a battery charging event, comprising: obtaining at least one quantified State of Health [SoH] indicator of the battery as output from a first machine-learning system; and feeding the obtained at least one quantified SoH indicator, together with battery charging data associated with the charging event, as input to a second machine-learning system, which provides an estimate of the anode potential of the battery as output.

Lithium plating happens when the anode potential of the battery becomes negative. However, it is complicated to install a sensor for measuring the anode potential of the battery directly. Therefore, an accurate and reliable data-driven model for estimating the anode potential has been developed.

Specifically, this disclosure provides a machine-learning framework that uses only the measurable signals (current, voltage, and temperature) from the battery management system to estimate the anode potential of the battery. This information can then be used to control the charging current to keep the anode potential always positive and avoid lithium plating onsite.

The comprehensive machine-learning (ML) framework consists of first and second ML systems developed for estimating the anode potential of the battery. Specifically, anode potential is only useful when the vehicle needs to perform fast charging. The first ML system is used to conduct battery aging status estimation and monitoring, primarily based on vehicle destination charging or home charging (low charging current). Then, using the output from the first ML system and the onsite current, voltage, and temperature measurement, a second ML system is developed that can estimate the anode potential of the battery, based in the SoH output of the first ML system.

Lithium plating generally only, or at least primarily, happens when the anode potential of the battery becomes negative, or comes close to be negative. Hence, based on the anode potential estimation described above, the charging current can be controlled to avoid plating and associated degradation, which means faster charging speed and longer battery lifetime at the same time.

To conclude, a systematic machine learning framework is developed to estimate the anode potential of the battery to enable the fastest charging of the battery substantially without sacrificing battery lifetime. Moreover, such a method can be used over the entire lifetime of the battery to incorporate situations when batteries are gradually aging.

Further advantages are achieved by implementing one or several of the features of the dependent claims.

In some example embodiments, that may be combined with any one or more of the above-described embodiments, the first machine-learning system, in connection with a charging events, frequently updates the at least one quantified SoH indicator based on battery charging data obtained from said charging events. Thereby, it is ensured that the one or more quantified SoH indicator are kept updated over the lifetime of the battery.

In some example embodiments, that may be combined with any one or more of the above-described embodiments, the first machine-learning system primarily or only updates the at least one quantified SoH indicator based on battery charging data obtained from charging events that are characterised by slow charging speed. This ensures improved quality of the estimated quantified SoH indicators.

In some example embodiments, that may be combined with any one or more of the above-described embodiments, the second machine-learning system primarily or only estimates the anode potential of the battery based on battery charging data obtained from charging events that are characterised by fast charging speed. Lithium plating is primarily of concern during fast charging the estimation of anode potential may therefore be dispensed from during slow charging event.

In some example embodiments, that may be combined with any one or more of the above-described embodiments, the at least one SoH indicator obtained as output from the first machine-learning system includes battery capacity as a first SoH indicator, and at least a first aging mode as a second SoH indicator.

In some example embodiments, that may be combined with any one or more of the above-described embodiments, the at least one SoH indicator obtained as output from the first machine-learning system additionally includes a second aging mode as a third SoH indicator, specifically also a third aging mode as a fourth SoH indicator.

In some example embodiments, that may be combined with any one or more of the above-described embodiments, the first aging mode is any of lithium inventory loss (LLI), loss of active materials in the negative electrode ($LAM_{NE}$), and loss of active material in the positive electrode ($LAM_{PE}$).

In some example embodiments, that may be combined with any one or more of the above-described embodiments, the first and second aging modes are any of lithium inventory loss (LLI), loss of active materials in the negative electrode ($LAM_{NE}$), and loss of active material in the positive electrode ($LAM_{PE}$).

In some example embodiments, that may be combined with any one or more of the above-described embodiments, the first, second and third aging modes are lithium inventory loss (LLI), loss of active materials in the negative electrode ($LAM_{NE}$), and loss of active material in the positive electrode ($LAM_{PE}$).

In some example embodiments, that may be combined with any one or more of the above-described embodiments, the at least one SoH indicator obtained as output from the first machine-learning system includes battery capacity as a first SoH indicator and at least a first aging mode as a second SoH indicator, wherein the first machine-learning system comprises a first machine learning model for estimating the battery capacity and a second machine learning model for estimating the first aging mode. Thereby, a dedicated machine learning model may be used for estimating each SoC indicator, thereby contributing to improved estimation quality.

In some example embodiments, that may be combined with any one or more of the above-described embodiments, the at least one SoH indicator obtained as output from the first machine-learning system includes battery capacity as a first SoH indicator and at least a first aging mode as a second SoH indicator, wherein the first machine-learning system comprises a single machine learning model for estimating both the battery capacity and the first aging mode. This provides a less complex implementation of the system.

In some example embodiments, that may be combined with any one or more of the above-described embodiments, the at least one SoH indicator obtained as output from the first machine-learning system includes battery capacity as a first SoH indicator, a first aging mode as a second SoH indicator, a second aging mode as a third SoH indicator, specifically also a third aging mode as a fourth SoH indicator, wherein the first machine-learning system comprises a first machine learning model for estimating the battery capacity and a second machine learning model for estimating all the aging modes.

In some example embodiments, that may be combined with any one or more of the above-described embodiments, the at least one SoH indicator obtained as output from the first machine-learning system includes battery capacity as a first SoH indicator, a first aging mode as a second SoH indicator, a second aging mode as a third SoH indicator, specifically also a third aging mode as a fourth SoH indicator, wherein the first machine-learning system comprises a single machine learning model for estimating both the battery capacity and all the aging modes. This provides a less complex implementation of the system.

In some example embodiments, that may be combined with any one or more of the above-described embodiments, the at least one SoH indicator obtained as output from the first machine-learning system includes battery capacity as a first SoH indicator, a first aging mode as a second SoH indicator, a second aging mode as a third SoH indicator, specifically also a third aging mode as a fourth SoH indicator, wherein the first machine-learning system comprises an individual machine learning model, such as Gaussian process regression (GPR), Bayesian regression (BR), random forest regression (RFR), or Neural Network (NN), for estimating each SoH indicator separately. Thereby, a dedicated machine learning model may be used for estimating each SoC indicator, thereby contributing to improved estimation quality.

In some example embodiments, that may be combined with any one or more of the above-described embodiments, the second machine-learning system is implemented as a long short-term memory network (LSTM) machine learning algorithm, an underestimate-enhanced long short-term memory (UE- LSTM) machine learning algorithm, or a neural network, specifically a gated recurrent unit (GRU) neural network or an artificial neural network (ANN).

In some example embodiments, that may be combined with any one or more of the above-described embodiments, the battery charging data includes charging current, charging voltage, and battery charging temperature. This battery charging data is relatively easily obtainable.

In some example embodiments, that may be combined with any one or more of the above-described embodiments, the method further comprising obtaining the battery charging data from a battery management system (BMS) configured for managing the battery. Thereby, the system and method according to the disclosure may be easily implemented in the battery charging system.

In some example embodiments, that may be combined with any one or more of the above-described embodiments, the first machine-learning system is trained based on battery charging data obtained from charging cycles characterised by a slow charging speed.

In some example embodiments, that may be combined with any one or more of the above-described embodiments, the second machine-learning system is trained based on battery charging data obtained from charging cycles characterised by fast charging speed. Lithium plating is primarily of concern during fast charging the estimation of anode potential, and therefore it is sufficient to train and use the second machine learning system during fast charging events.

The disclosure also relates to a method for performing fast charging of a battery while reducing the risk for lithium plating, wherein the method comprises controlling the charging current such that a battery anode potential is above a threshold value, wherein the battery anode potential is estimated according to any of the methods describes above. Battery plating is typically closely related to the battery anode potential level.

The disclosure also relates to a computer program for real-time estimation of an anode potential of a battery in connection with a battery charging event, wherein the computer program comprises a computer-readable instructions which, when executed by a computer, causes the computer to obtain at least one quantified State of Health [SoH] indicator of the battery as output from a first machine-learning system, and feed the obtained at least one quantified SoH indicator, together with battery charging data associated with the charging event, as input to a second machine-learning system, which provides an estimate of the anode potential of the battery as output.

The disclosure also relates to a system for real-time estimation of an anode potential of a battery in connection with a battery charging event, the system comprising one or more processors configured to: obtain at least one quantified State of Health [SoH] indicator of the battery as output from a first machine-learning system, and feed the obtained at least one quantified SoH indicator, together with battery charging data associated with the charging event, as input to a second machine-learning system, which provides an estimate of the anode potential of the battery as output.

Further features and advantages of the invention will become apparent when studying the appended claims and the following description. The skilled person in the art realizes that different features of the present disclosure may be combined to create embodiments other than those explicitly described hereinabove and below, without departing from the scope of the present disclosure.

To conclude, for enabling a shift from fossil fuels to renewable and sustainable transport, batteries must support fast charging and exhibit extended lifetimes-objectives that traditionally conflict. Current charging technologies often compromise one attribute for the other, leading to either inconvenience or diminished resource efficiency in battery-powered vehicles. In this disclosure, this challenge is addressed by introducing a novel method that involves real-time monitoring and control of the plating potential in lithium-ion battery cells throughout their lifespan. The experimental results on three-electrode cells reveal that this approach enables batteries to charge at least 30% faster without sacrificing, but rather doubling their lifetime. To facilitate the adoption of these findings in commercial applications, a machine learning-based framework for lifelong plating potential estimation is proposed, utilizing readily available battery data from electric vehicles. The resulting model demonstrates high fidelity and robustness under diverse operating conditions, achieving a mean absolute error of merely 3.37 mV. This disclosure outlines a practical methodology to prevent lithium plating and enable the health-conscious fastest battery charging.

BRIEF DESCRIPTION OF DRAWINGS

The method and system for anode potential estimation according to the disclosure will be described in detail in the following, with reference to the attached drawings, in which

Fig. 1a    shows an EL-cell three-electrode cell holder,

Fig. 1b    shows the internal structure of the cell and the measured signals, including the cell voltage Ucell and the anode voltage,

Fig. 1c    shows the current and anode potential profiles of a studied cell at different aging levels and under CC-C$\eta$ charging,

Fig. 1d    shows the current and anode potential profiles of another studied cell under CC-CV charging,

Fig. 1e    shows the aging curves of four cells experiencing two different charging strategies,

Fig. 2 shows an example embodiment of a machine learning framework for lifelong estimation of battery plating potential,

Fig. 3a shows the estimation results (histogram) of the four SoH indicators for batteries operated under the full SoC window, for all data samples in the test set,

Fig. 3b shows the estimated trajectories against their ground truth for a randomly selected cell of the estimation results of the four SoH indicators for batteries operated under the full SoC window,

Fig. 4a shows estimation results for the plating potential, specifically the distribution of estimation errors for Model 3.

Fig. 4b shows estimation results for the plating potential, specifically the cumulative absolute errors of Model 3 in comparison with four alternative models, each characterized by distinct input variables.

Fig. 4c shows estimation results for the plating potential, specifically contrasting the plating potential estimated by Model 3 against the experimentally measured profile for a randomly selected cell throughout its lifespan.

Fig. 4d shows estimation results for the plating potential, specifically the violin plot of the estimation errors on the test dataset using the proposed UE-LSTM and conventional LSTM, where the horizontal lines represent the mean errors.

Fig. 4e shows estimation results for the plating potential, specifically the probability distribution of accumulative estimation errors using UE-LSTM and LSTM models.

Fig. 4f shows estimation results for the plating potential, specifically the estimation errors and R2 score for plating potential when using measurements polluted by different levels of noise.

Fig. 5 shows a BEV or HEV having a battery anode estimation system as described herein.

DESCRIPTION OF EXAMPLE EMBODIMENTS

Various aspects of the disclosure will hereinafter be described in conjunction with the appended drawings to illustrate and not to limit the disclosure, wherein like designations denote like elements, and variations of the described aspects are not restricted to the specifically shown embodiments, but are applicable on other variations of the disclosure.

At the forefront of a transition to sustainable mobility are lithium-ion (Li-ion) batteries, celebrated for their high energy density, cost-effectiveness, and durability, establishing themselves as the primary power source for electric vehicles (EVs). Yet, as the industry strives to match the convenience of traditional fuelling methods, it encounters significant hurdles in fast-charging technology that do not compromise battery lifespan.

Rapid charging introduces a paradox; on one hand, it necessitates high current levels, leading to excessive heat generation that, if not adequately dissipated through advanced thermal management systems, can significantly accelerate many battery aging mechanisms, e.g., the solid electrolyte interface (SEI) growth. On the other, even when thermal issues are addressed, the escalated current can trigger intricate mechanical and electrochemical reactions within the battery, further exacerbating its degradation.

Among the myriad of factors influencing battery degradation during fast charging, lithium plating emerges as a critical concern. This phenomenon-characterized by the deposition of metallic lithium on the anode's surface-directly undermines the battery's capacity and efficiency by impeding the normal intercalation process.

The quest to accurately gauge and control the plating potential underscores the complexity of translating theoretical models into actionable strategies. Traditional approaches, ranging from direct measurements to sophisticated estimation algorithms based on equivalent-circuit or physics-based battery models face practical limitations in terms of cost, complexity, and potential interference with battery operations. This predicament strongly solicits innovative approaches to prevent lithium plating during battery fast charging.

The integration of cloud battery management systems (BMS) and the systematic collection of battery operational data have spurred the advancement of data-driven methodologies. These methods have shown remarkable proficiency in diagnosing and prognosticating battery conditions, including state of charge (SoC), state of health (SoH), and remaining useful life (RUL). However, the application of data-driven strategies specifically for estimating plating potential to avert lithium plating during charging is still in its infancy.

This disclosure endeavours to reconcile theoretical insights with practical applications in the fast charging of batteries, driven by two principal innovations. Initially, the effectiveness of a plating potential controlled charging method is validated using three-electrode battery cells, demonstrating marked improvements in both battery lifetime and charging efficiency over conventional methods. Building upon this foundation, an innovative ML-based framework for the lifelong estimation of battery plating potential, also referred to as battery anode potential, was developed. This framework adeptly utilizes real-time time-series measurements to learn electrochemical behaviours on a fast timescale alongside online estimated SoH indicators that learn the effect of aging on plating potential. Comprehensive validation of the present framework through extensive battery cycling data under diverse operating conditions and aging levels underscores its robustness and accuracy. These innovations collectively represent a significant stride towards health-aware, fast charging solutions for EV batteries.

*Three-electrode cell experiments*

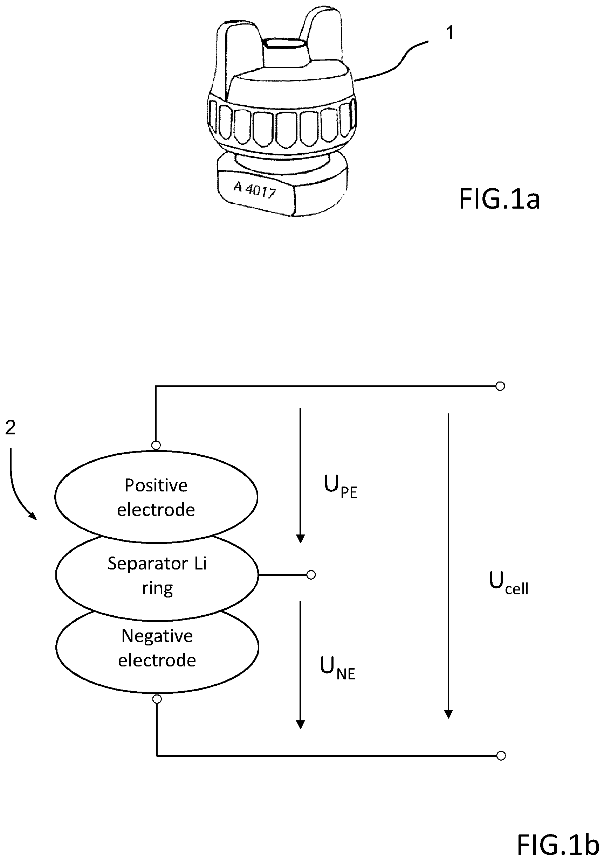

In the experimental setup, the EL-CELL PAT-Cellwas used for testing three-electrode cells, as illustrated in Fig. 1a-b. To assemble the three-electrode cells, Nickle Manganese Cobalt (NMC) oxides of type 811 were used as the positive electrode, and artificial graphite was used as the negative electrode, both supplied by Customcells Itzehoe GmbH. All the cell assembling operations were carried out in an argon-filled glove box. First, the electrode sheets were die-cut to a coin size with a diameter of 18 mm. Then, the positive and negative electrodes were assembled into the PAT-Cell stack sequentially. Borosilicate glass fibre separators (260 $\mu$m, Whatman FG/A) were used, in which a lithium metal ring served as a reference electrode to measure the electrode potential during battery operation. The electrolyte used was a 90 $\mu$L lithium hexafluorophosphate solution in a mixture of ethylene carbonate and dimethyl carbonate (LiPF6 LP50). The nominal capacity of the three-electrode cells is 5 mAh, which will be used as the basis to define C-rates in subsequent test instructions.

The experimental procedures were carried out within a controlled temperature chamber of type ESPEC LHU-124, utilizing the PAT-Stand-1 cell holder, and subjected to cycling using a NEWARE coin cell cycler. The temperature chamber was maintained at a constant temperature of 25°C. After the assembly of the cells, a formation cycle was executed following the guidelines provided by Customcells. The formation cycle profile was first, according to Profile 1, repeated twice as listed in Table 1, then following Profile 2, repeated twice. To assess the aging status of the battery cells, reference performance tests (RPTs) were scheduled every 25 normal cycles. During these tests, Profile 3 was executed twice, and the average value of the two discharge capacities was defined as the cell's reference capacity.

Table 1: CC-CV charging and CC discharging profiles for the designed three-electrode cell experiment.

|  |  | Charge phase | | | Discharge phase | |
|---|---|---|---|---|---|---|
|  |  | Current | Voltage limit | Cut-off condition | Current | Voltage limit |
| CC-CV | Profile 1 | 0.1C | 4.2V | 1/25C | 0.1C | 3V |
|  | Profile 2 | 0.2C | 4.2V | 1/25C | 0.2C | 3V |
|  | Profile 3 | 1C | 4.2V | 1/10C | 1C | 3V |
|  | Profile 4 | 1.5C | 4.2V | 1/10C or4 mAh | 1C | 3V |
| CC-C$\eta$ | Profile 5 | 2C | 4.5V | 4 mAh | 1C | 3V |

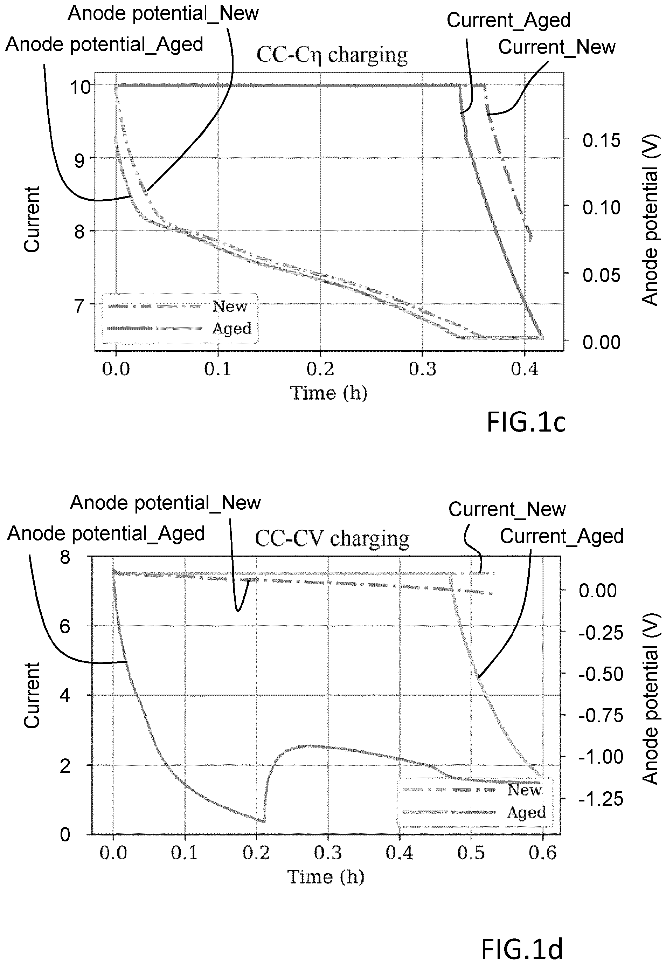

In this disclosure, a total of four cells were assembled and used in the experimental campaign. Two of the cells served as a reference group, undergoing constant current-constant voltage (CC-CV) charging according to Profile 4 in Table 1. The charging process for these cells was terminated when the current met 0.1C or the accumulated charged capacity reached 4 mAh, which is equivalent to 80% of the nominal capacity (see Fig. 1d). The remaining two cells were operated under a lithium-plating-free charging strategy, wherein the charging current was controlled to maintain non-negative voltage between the plating potential ($\eta$) and the reference electrode (Li/Li+), ensuring UNE $\geq$ 0. Designated as Profile 5 and referred to as CC-C$\eta$ charging, this approach constituted the experimental group for advanced comparative analysis (depicted in Fig. 1c). Here, a higher current value was adopted in the CC stage for CC-C$\eta$ charging compared to CC-CV, ensuring that the two strategies have comparable charging durations. This arrangement facilitates a direct comparison of their effects on battery degradation. For all the defined tests, data on current, voltage, temperature, and plating potential was measured and collected at a sampling frequency of 1 Hz.

*Synthetic data generation*

To cover wide operating conditions and diverse aging trajectories that batteries may encounter in real-world applications, synthetic data was generated by simulating a single particle model, including electrolyte dynamics (SPMe), and coupled with several aging mechanisms. Until now, no universally accepted model covers all aging mechanisms possibly triggered in typical Li-ion batteries. In this regard, three major aging mechanisms are considered in this simulation, including the SEI layer growth in the anode and the loss of active materials in the anode and cathode. For a more detailed introduction to the employed SPMe-aging model, readers are directed to the literature works of: J. S. Edge, S. O'Kane, R. Prosser, N. D. Kirkaldy, A. N. Patel, A. Hales, A. Ghosh, W. Ai, J. Chen, J. Yang, et al., Lithium ion battery degradation: what you need to know, Phys. Chem. Chem. Phys. 23 (14) (2021) 8200-8221; S. J. Moura, F. B. Argomedo, R. Klein, A. Mirtabatabaei, M. Krstic, Battery state estimation for a single particle model with electrolyte dynamics, IEEE Trans. Control Syst. Technol. 25 (2) (2016) 453-468; and S. E. O'Kane, W. Ai, G. Madabattula, D. Alonso-Alvarez, R. Timms, V. Sulzer, J. S. Edge, B. Wu, G. J. Offer, M. Marinescu, Lithium-ion battery degradation: how to model it, Phys. Chem. Chem. Phys. 24 (13) (2022) 7909-7922.

It is worth mentioning that apart from these three aging mechanisms, lithium plating is as one of the major aging mechanisms during the usage of Li-ion batteries, particularly under conditions of large charging currents, low temperatures, high SoC levels, and in aged cells.

The model-based simulation offers unparalleled efficiency in terms of time and energy consumption and exhibits remarkable flexibility in configuration. This facilitates the development of advanced health management strategies for next-generation BMS, presenting a significant advantage over conventional experimental methodologies.

By varying aging-related parameters sequentially, the above battery model was simulated extensively on the platform PyBaMM under a wide range of operating conditions (as detailed in Section "Physical parameters and simulation conditions". The simulations that were conducted resulted in a large synthetic dataset consisting of two parts. One part of the dataset includes time-series data of current, voltage, temperature, and plating potential recorded at a sampling rate of 1 Hz. The other part contains four SoH indicators, i.e., the battery capacity, lithium inventory loss (LLI), loss of active materials in the negative electrode ($LAM_{NE}$), and loss of active material in the positive electrode ($LAM_{PE}$), recorded at the end of each RPT cycle. With the end of life defined as 80% of the nominal capacity, it can be seen that the battery lifetimes corresponding to different parameter settings span from 20 to 2000 cycles. Further details for the employed battery model and its implementation are introduced in Section *"Electrochemical battery modelling and simulation"*.

*Lifelong estimation framework for plating potential*

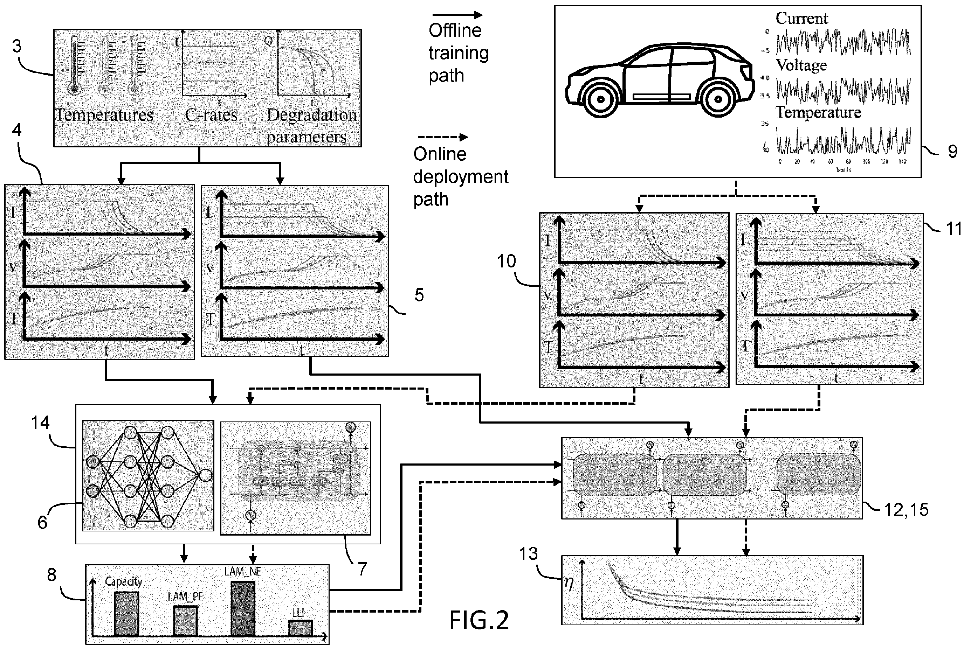

According to a first embodiment of this disclosure, an innovative framework designed for the lifelong estimation of plating potential is introduced, as illustrated in Fig. 2. The lifelong estimation of plating potential is based on two pivotal tasks executed through the integration of three machine learning (ML) models. Specifically, in this example embodiment the framework employs Model 1 for estimating the battery's capacity, Model 2 for quantifying the three aging modes both on a slow timescale and Model 3 for estimating the plating potential on a fast timescale. This structured framework leverages the strengths of each model to deliver an accurate, robust, and real-time estimation of the plating potential over the battery's lifespan.

For Model 1, the inputs, also called features, may be manually constructed from time-series and histogram-based raw data, e.g., the slope of the voltage curves and the accumulated energy throughput. The output of this model is battery capacity.

For Model 2, the inputs include time-series current, voltage, and temperature measurements, while the outputs are the three aging modes (namely LLI, $LAM_{PE}$, and $LAM_{NE}$). Considering the nature of slow aging dynamics, Model 1 and Model 2 are developed from the data collected during PRT tests, which, as specified in Section "Synthetic data generation", were conducted every 25 normal cycles. For real-world vehicle applications, the data samples for training these two ML models can be collected during destination charging, in which the charging current is low (often lower than 1/8C). This fosters beneficial conditions, such as wide SoC ranges, relatively stable temperatures, and mild lithium diffusion processes, for extracting high-quality data samples. To label the four SoH indicators as the model output, the battery capacity can be calibrated according to Profile 3 of Section *"Three-electrode cell experiments"*, and the three aging modes are calculated from the open-circuit voltage (OCV).

With the plating potential as the unique output, Model 3 has two types of inputs. The first type of input comprises time-series current, voltage, and temperature measurements, from which fast battery dynamics can be learned. As the ultimate target is to optimize battery charging performance in real-time, the input data could be extracted from the corresponding fast charging profile. The second type is the four outputs from Model 1 and Model 2, which is used to inform Model 3 of the slowly aging characteristics of battery health. Essentially, Model 3 combines time-series and non-temporal features to adaptively estimate the plating potential over the battery's entire lifetime. Furthermore, to pave the way for later conservative fast-charging control implementation, an underestimated plating potential result is preferred compared to an overestimate. An underestimate-enhanced long short-term memory (UE- LSTM) is proposed to refine the precision of plating potential estimations while inherently biasing towards underestimations. This approach not only ensures the accuracy of the predictions but also strategically aligns with the preference for conservative estimations in the context of fast-charging control mechanisms.

Model 1 and Model 2 may be deemed forming a first machine learning system, because it is a ML-system that provides quantified estimates of SoH indicators (both Model 1 and Model 2 provides quantified estimates of SoH indicators as output). As discussed below, the estimation of the SoH indicators may in fact in some example embodiments be performed by a single ML model, or by a system of individual ML models.

Similarly, Model 3 may be deemed forming a second machine learning system, because also the task of providing an estimate of the anode potential (plating potential) as output based on battery fast charging data as first type of input and quantified estimates of SoH indicators as second type of input. The estimation of the anode potential may in fact in some example embodiments be performed by a system of individual ML models, for example by fusing the output result of a plurality of individual ML models.

In the proposed framework, the first and second machine learning systems operate in parallel. At low current rates, such as those encountered during destination charging, the risk of lithium plating diminishes, reducing the necessity for real-time plating potential estimation. In such circumstances, it may be unnecessary to activate the second machine learning system (Model 3). Conversely, during fast charging sessions, precise estimation of the plating potential becomes critical to prevent lithium plating, highlighting the critical role of the second machine learning system (Model 3). It is worth mentioning that this framework can be seamlessly integrated with existing vehicle BMS, utilizing readily available measurements. This integration enables onsite quantification of all these SoH indicators and real-time estimation of the plating potential.

*Results of the three-electrode cell test*

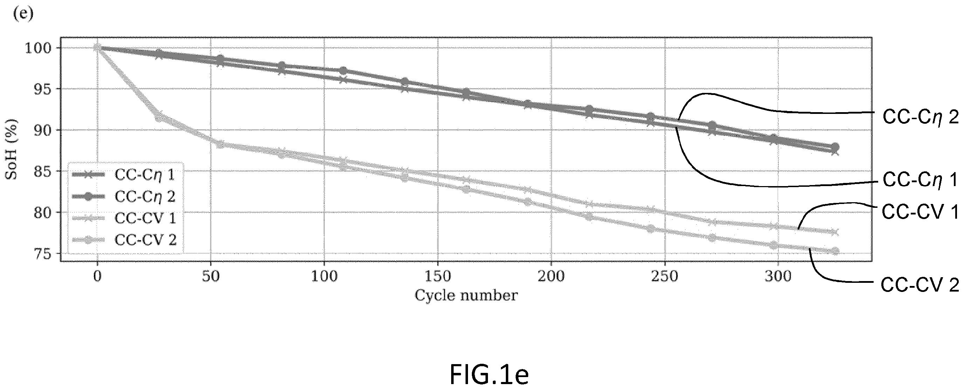

By implementing the experiments designed in Section "Three-electrode cell experiments", the aging trajectories of all the studied battery cells can be obtained, as depicted in Fig. 1e. This disclosure represents the first published experimental result that directly measure the plating potential and use it to dynamically control the charging current in a closed-loop fashion during the battery's lifelong operation. It can be seen that at the end of the test, corresponding to 325 normal cycles, both cells in the CC-CV group had passed their end of life, with a SoH below 80%. Specifically, these cells suffered from a sharp capacity loss, i.e., 12% of the nominal capacity, within the first 50 cycles, attributed to the onset of lithium plating, as evidenced by the negative plating potential shown in Fig. 1d. In contrast, the two cells in the CC-C$\eta$ group were able to retain an SoH above 87% beyond the 325th cycle, suggesting a markedly extended lifespan compared to their counterparts. This improvement is derived from the CC-C$\eta$ charging strategy, which, by continuously monitoring the plating potential and ensuring its non-negativity.

Beyond extending battery lifetime, the CC-C$\eta$ charging strategy significantly surpassed CC-CV charging in terms of efficiency, achieving a 30% reduction in charging time during the initial cycle and a 40% reduction by the 200th cycle, as illustrated in Fig. 1c-d.

The above experimental results demonstrate that real-time control of the charging profile based on the plating potential ($\eta$) can significantly extend battery lifetime while enabling faster charging. These findings not only confirm the viability of health-aware fastest charging but also point out how to achieve it. This laboratory experiment result strongly motivates the lifelong estimation of $\eta$ in Section *"Lifelong estimation framework for plating potentiaf'*, given it is not economically feasible to incorporate reference electrodes into each commercial battery.

Conventionally, the evaluation of a given charging strategy concerning battery degradation and lifetime relies heavily on extensive experiments over thousands of cycles, especially considering diverse operating conditions. As per the results in Fig. 1a-e, the long-term effects of different charging strategies on battery health can be largely revealed by the profile of $\eta$ in the early cycling stage, which thus significantly mitigates the need for extremely time-consuming and expensive experiments. This benefit will, in turn, accelerate the improvement and optimization process of existing battery materials and design for faster charging and a longer lifetime.

To conclude, the present disclosure provides a computer-implemented method for real-time estimation of an anode potential of a Lithium-Ion battery in connection with a battery charging event, in particular a battery fast charging event. The method comprises: obtaining at least one quantified State of Health [SoH] indicator of the battery as output from a first machine-learning system; and feeding the obtained at least one quantified SoH indicator, together with battery charging data associated with the charging event, as input to a second machine-learning system, which provides an estimate of the anode potential of the battery as output based on said input.

Each of the first and second machine-learning systems may be an individual machine-learning system. Moreover, the battery charging data associated with the charging event may be extracted from an ongoing or planned charging event.

The term "in connection with" here means that the calculation for determining the estimation of the anode potential of the Lithium-Ion battery for example may be performed slightly before and/or during the actual battery charging event. The estimation may also be repeated during the charging event in response to changes of the charging current, or the like.

For ensuring that the quantified SoH indicators are maintained updated during use of the battery, the first machine-learning system is configured to frequently updates the at least one quantified SoH indicator based on battery charging data obtained from said charging events.

Such updates will typically be performed in connection with the charging events. For example, the quantified SoH indicators may be updated in connection with each charging event, each n'th charging event where n is the range of 2 to 30, or at least relatively often. It is relevant to perform the update recurrently over the lifetime of the battery for keeping the quantified SoH indicators may be updated.

The battery charging data may be obtained from synthetic battery data generation, from computer simulated battery data, or other types of offline battery data generation. Alternatively, or in combination thereto, battery charging data may be obtained from real-time (online) charging events of the battery.

Specifically, the first machine-learning system primarily or only updates the at least one quantified SoH indicator based on battery charging data obtained from charging events that are characterised by slow charging speed. The term slow charging speed herein refers to low charging power during a long time period, such as for example destination charging or similar type of "low charging rate" charging events. Destination charging typically involves slow charging during a night, or at least over several hours. This can be contrasted to "fast charging speed", which typically refers to high charging power during a short time period, such as charging at a supercharger. Low charging power means for example up to 15 kW, or up to 25 kW, while high charging power means for example 15 kW and above, specifically 25kW and above.

As discussed above, plating generally only occurs during high power charging event. Consequently, the second machine-learning system primarily or only estimates the anode potential of the battery based on battery charging data obtained from charging events that are characterised by fast charging speed. During slow charging speed event, there is generally no need to adapt the charging current to avoid lithium plating, and thus no need for calculating an estimate of the anode potential.

As discussed above, the at least one SoH indicator obtained as output from the first machine-learning system may for example include battery capacity as a first SoH indicator, and at least a first aging mode as a second SoH indicator.

Furthermore, the at least one SoH indicator obtained as output from the first machine-learning system additionally may include a second aging mode as a third SoH indicator, specifically also a third aging mode as a fourth SoH indicator.

In some example embodiments, the first aging mode may be any of lithium inventory loss (LLI), loss of active materials in the negative electrode ($LAM_{NE}$), and loss of active material in the positive electrode ($LAM_{PE}$).

In some example embodiments, the first and second aging modes are any of lithium inventory loss (LLI), loss of active materials in the negative electrode ($LAM_{NE}$), and loss of active material in the positive electrode ($LAM_{PE}$).

In some example embodiments, the first, second and third aging modes are lithium inventory loss (LLI), loss of active materials in the negative electrode ($LAM_{NE}$), and loss of active material in the positive electrode ($LAM_{PE}$).

As discussed above, the at least one SoH indicator obtained as output from the first machine-learning system may include battery capacity as a first SoH indicator and at least a first aging mode as a second SoH indicator, wherein the first machine-learning system comprises a first machine learning model for estimating the battery capacity and a second machine learning model for estimating the first aging mode.

Furthermore, according to another example embodiment, the at least one SoH indicator obtained as output from the first machine-learning system may include battery capacity as a first SoH indicator and at least a first aging mode as a second SoH indicator, wherein the first machine-learning system comprises a single machine learning model for estimating both the battery capacity and the first aging mode.

In some example embodiments, the at least one SoH indicator obtained as output from the first machine-learning system includes battery capacity as a first SoH indicator, a first aging mode as a second SoH indicator, a second aging mode as a third SoH indicator, specifically also a third aging mode as a fourth SoH indicator, wherein the first machine-learning system comprises a first machine learning model for estimating the battery capacity and a second machine learning model for estimating all the aging modes.

According to another example embodiment, the at least one SoH indicator obtained as output from the first machine-learning system includes battery capacity as a first SoH indicator, a first aging mode as a second SoH indicator, a second aging mode as a third SoH indicator, specifically also a third aging mode as a fourth SoH indicator, wherein the first machine-learning system comprises a single machine learning model for estimating both the battery capacity and all the aging modes.

According to still another example embodiment, the at least one SoH indicator obtained as output from the first machine-learning system includes battery capacity as a first SoH indicator, a first aging mode as a second SoH indicator, a second aging mode as a third SoH indicator, specifically also a third aging mode as a fourth SoH indicator, wherein the first machine-learning system comprises an individual machine learning model, such as Gaussian process regression (GPR), Bayesian regression (BR), random forest regression (RFR), or Neural Network (NN), for estimating each SoH indicator separately.

In some example embodiments, the second machine-learning system is implemented as a long short-term memory network (LSTM) machine learning algorithm, or an underestimate-enhanced long short-term memory (UE-LSTM) machine learning algorithm, or a neural network, specifically a gated recurrent unit (GRU) neural network or an artificial neural network (ANN).

In some example embodiments, the battery charging data includes at least charging current, charging voltage, and battery temperature. Further battery parameters may alternatively be used, such as for example estimated State of Charge (SoC) and/or battery internal resistance.

In some example embodiments, the method further comprises obtaining the battery charging data from a battery management system (BMS), which is configured for managing the battery.

The BMS may for example be configured for also protecting the battery from low/high state of charge, for monitoring operating state of the battery, controlling battery environment, and/or performing battery cell voltage balancing, etc.

In some example embodiments, the first machine-learning system is trained based on battery charging data obtained from charging cycles characterised by a slow charging speed.

In some example embodiments, the second machine-learning system is trained based on battery charging data obtained from charging cycles characterised by fast charging speed.

For both slow and fast charging speeds, the battery charging data may for example be obtained offline from synthetic data generation, simulated battery charging/discharging cycling, etc. Alternatively, or in combination thereto, the battery charging data may be obtained in real-time, i.e. online, by sampling relevant battery parameters, such as current, voltage and battery temperature, at a suitable sampling frequency, during real charging events.

The present disclosure also relates to a method for performing fast charging of a battery while reducing the risk for lithium plating. The method comprises controlling the charging current such that a battery anode potential is above a threshold value, wherein the battery anode potential is estimated according to the method as described above.

The threshold value may be a predetermined fixed value, such as zero, or close to zero. For example, the threshold value may be within a range of -0.1V to 0.1V. Alternatively, the threshold value may be within a range of 0 to 0.3V, or above. Still more alternatively, the threshold value may be variable value that is a function of some battery relevant variable, such as battery temperature. In some example embodiments, the charging current is controlled to maintain non-negative anode potential.

*Estimation results of SoH indicators*

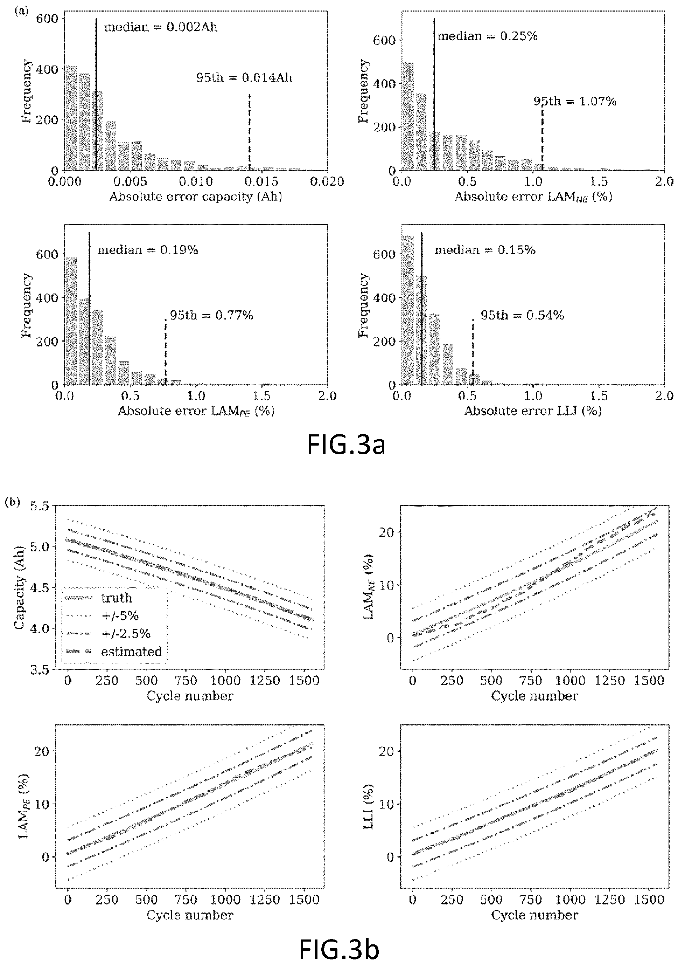

By implementing Model 1 and Model 2 from the proposed framework under the full SoC operating window, the results for estimating the four SoH indicators are presented in Fig. 3a and the first two rows of Table 2. The models exhibit high estimation fidelity for all the SoH indicators, achieving a mean absolute error (MAE) below 0.4% and a root-mean-square error (RMSE) under 0.55%. Furthermore, although the estimation of $LAM_{NE}$ results in the highest average error among all the indicators, the absolute error remains within 1.07% for 95% of the test dataset, underscoring the model's high accuracy and robustness across a broad spectrum of operating conditions. The estimation accuracy is slightly lower in $LAM_{NE}$ compared to $LAM_{PE}$. The relatively reduced accuracy in $LAM_{NE}$ estimations, as compared to $LAM_{PE}$, may be attributed to the more flat open-circuit potential (OCP) of the anode compared to that of the cathode, which complicates the discernment of $LAM_{NE}$ variations via the cell's current and voltage. For further examination, a battery cell is randomly selected. The estimation trajectories for each SoH indicator over the entire lifetime are shown in Fig. 3b. As can be seen, the estimates closely follow the calibrated values, with the maximum estimation errors falling within the $\pm2.5\%$ error bounds.

In real-world vehicular applications, battery discharge and charge cycles rarely span the full 0-100% SoC window. Instead, batteries typically undergo various partial charging cycles, including the aforementioned destination charging for EVs. This context necessitates a comprehensive evaluation of the developed ML models for SoH indicator quantification under realistic charging conditions. Accordingly, the performance of Model 1 and Model 2 is assessed across six distinct usage scenarios, each characterized by a unique SoC window. Table 2 presents the estimation errors for the four SoH indicators across these scenarios. Despite a slight reduction in accuracy relative to the full SoC window scenario, the obtained estimates maintain high reliability, with the average errors remaining below 1% for all the scenarios and SoH indicators. These results verify the effectiveness and real-world applicability of Model 1 and Model 2 within the proposed estimation framework. More results regarding the overall estimation errors under different usage.

Table 2: Estimation results for battery SoH indicators under different charging scenarios.

| SoC window (%) | | Capacity (Ah) | $LAM_{NE}$ (%) | $LAM_{PE}$ (%) | LLI (%) |
|---|---|---|---|---|---|
| 0-100 | MAE | 0.004 | 0.375 | 0.269 | 0.200 |
| | RMSE | 0.007 | 0.546 | 0.439 | 0.289 |

(continued)

| SoC window (%) | | Capacity (Ah) | LAM$_{NE}$ (%) | LAM$_{PE}$ (%) | LLI (%) |
|---|---|---|---|---|---|
| 20-50 | MAE | 0.005 | 0.458 | 0.268 | 0.232 |
| | RMSE | 0.008 | 0.702 | 0.421 | 0.370 |
| 30-60 | MAE | 0.006 | 0.603 | 0.344 | 0.241 |
| | RMSE | 0.009 | 0.777 | 0.887 | 0.872 |
| 40-70 | MAE | 0.007 | 0.470 | 0.451 | 0.312 |
| | RMSE | **0.010** | 0.789 | 0.641 | 0.432 |
| 50-80 | MAE | 0.007 | 0.580 | 0.633 | 0.398 |
| | RMSE | **0.010** | 0.880 | **0.982** | **0.586** |
| 60-90 | MAE | 0.006 | 0.557 | 0.393 | 0.255 |
| | RMSE | 0.009 | 0.859 | 0.673 | 0.408 |
| 70-100 | MAE | 0.006 | 0.544 | 0.385 | 0.161 |
| | RMSE | 0.009 | **0.956** | 0.578 | 0.245 |

*Lifelong plating potential estimation*

1) Noise specification for model training. In the development of Model 3 within the present estimation framework, uncertainties inherent to the estimation of SoH indicators and the measurement of current, voltage, and temperature encountered in real-world applications has been accounted for. This is achieved by augmenting the training dataset with Gaussian white noise, thereby simulating the influence of estimation and measurement inaccuracies on model training. For all four SoH indicators, the noise is calibrated based on the most challenging real-world conditions, using the largest RMSE observed across the six partial charging scenarios (as highlighted in Table 2) to define the standard deviation of the Gaussian noise. The incorporation of measurement noise for current, voltage, and temperature is grounded in the specifications and empirical insights pertaining to widely utilized battery sensor technologies. Specifically, sensor noise with standard deviations corresponding to Level 4 defined in Table 4 has been simulated.

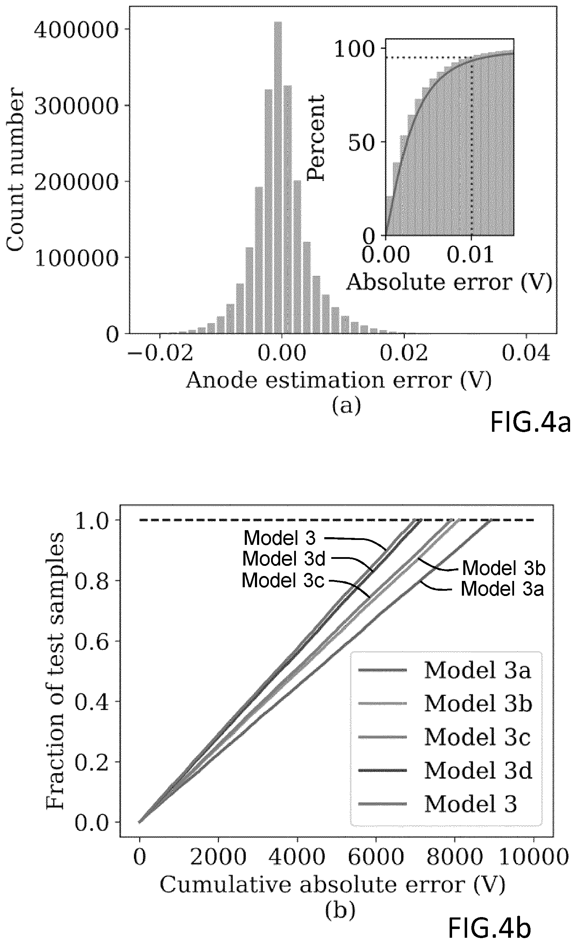

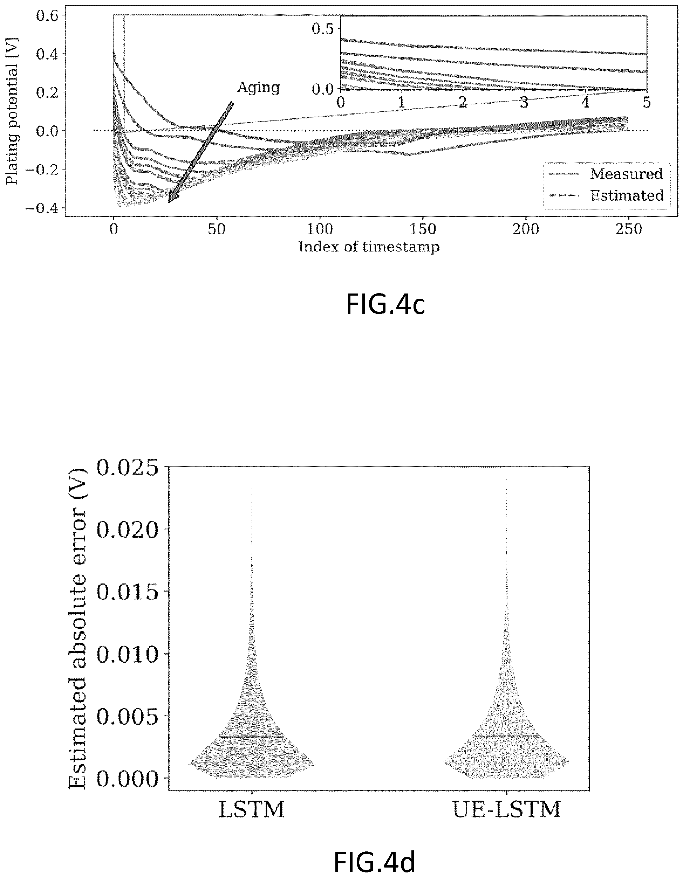

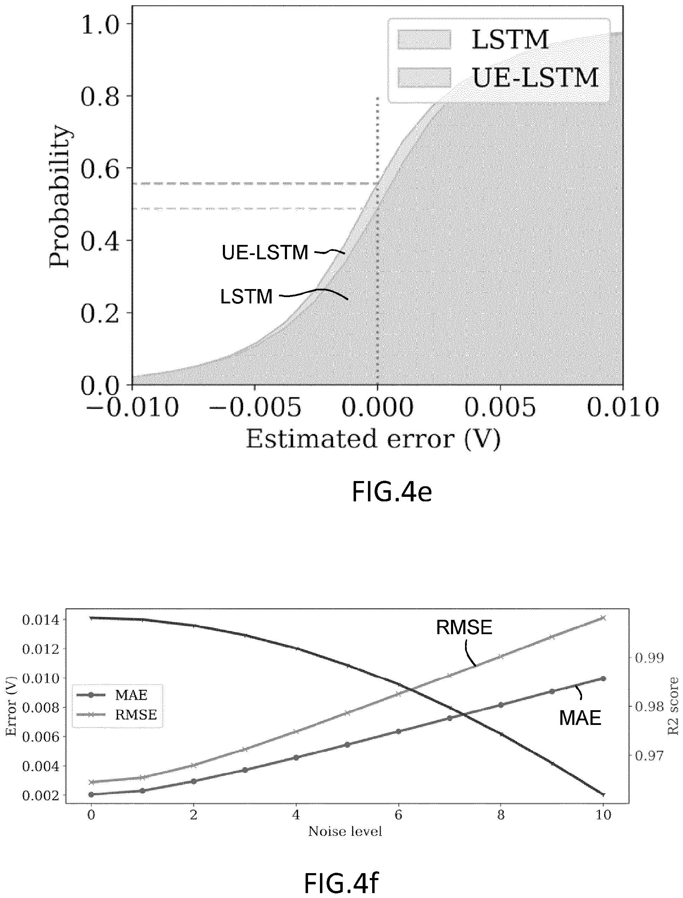

2) The overall performance of Model 3. The examination of the plating potential estimation, as delineated in Fig. 4, reveals that Model 3 is capable of predicting the battery's plating potential with a high degree of accuracy over the entire lifespan, limiting the maximum error to under 20 mV. This precision is further highlighted in the zoomed-in section of Fig.4a, where the cumulative error histogram demonstrates that 95% of estimations maintain an absolute error below 10 mV. Further quantitative analysis, represented in the last row of Table 3, showcases that the model has an MAE of 3.37 mV and an RMSE of 4.77 mV. These values affirm the model's high fidelity and robustness in estimating the plating potential across diverse operating conditions.

A detailed case study, illustrated in Fig. 4c, tracks the plating potential estimation for a randomly selected cell throughout its lifespan. The performance in estimating plating potentials near 0 V, essential for optimizing battery charging performance, is highlighted in the zoomed-in figure. This in-depth analysis reveals the model's capacity to not only follow the cell's true trajectory of plating potential closely but also to adapt dynamically to its aging status.

3) The effect of different SoH indicators. Four SoH indicators have been integrated into the feature set of Model.

However, there is no systematic study on the importance of individual SoH indicators for plating potential estimation. To fill the gap, the number of SoH indicators utilized inside the model have been changed, resulting in four alternative models characterized by distinct input variables, where Model 3a utilizes only the directly measured current, voltage, and temperature (see Table 3 for details).

It is observed from Table 3 and Fig. 4b that with an increasing number of SoH indicators added to the feature set, the model accuracy can be improved consistently, regardless of the number of data samples tested. Furthermore, leveraging the full array of SoH indicators, Model 3 markedly outperforms all its counterparts that lack comprehensive aging information. In comparison to Model 3a, Model 3 achieves a reduction in the MAE and RMSE by 22% and 24%, respectively. This enhancement in predictive accuracy confirms the importance of including detailed information on battery capacity and aging modes within the estimation framework.

4) The effect of different ML models. To evaluate the effectiveness of the proposed UE-LSTM in the development of Model 3, three alternative ML algorithms were implemented for comparison: the gated recurrent unit (GRU) neural network, an artificial neural network (ANN), and a conventional LSTM (see Section *"UE-LSTM for plating potential estimation"* for details).

The comparative analysis between LSTM and UE-LSTM is illustrated in Fig. 4d-e. Although the overall performance in estimation accuracy of these two algorithms is similar, a notable distinction is observed in the nature of estimation errors. Specifically, 56% of the estimation errors generated by the UE-LSTM are attributable to underestimation, marking a 7% increase compared to the conventional LSTM. This underestimation characteristic of UE-LSTM implies a potential for providing larger safety margins in the design of control strategies based on the estimated plating potential.

Table 3: Estimation results of the plating potential using different feature sets.

|  | Feature input | MAE (mV) | RMSE (mV) |
|---|---|---|---|
| Model 3a | Current ($I$), Voltage ($U$), Temperature ($T$) | 4.30 | 6.28 |
| Model 3b | $I, U, T,$ Capacity | 3.91 | 5.71 |
| Model 3c | $I, U, T,$ Capacity, LLI | 3.82 | 5.39 |
| Model 3d | $I, U, T,$ Capacity, LLI, $LAM_{NE}$ | 3.44 | 4.88 |
| Models | $I, U, T,$ Capacity, LLI, $LAM_{PE}$, $LAM_{NE}$ | 3.37 | 4.77 |

5) The effect of different levels of measurement noise. For real-world battery applications, such as EVs, the accuracy of signals measured from batteries often deviates from laboratory environments due to the need to balance sensor costs against precision. Given these challenges, it is crucial for the developed estimation model to possess robustness against sensor noise. For a comprehensive evaluation, ten levels of Gaussian white noise to current, voltage, and temperature measurements were introduced, with their standard deviations defined in Table 4.

The results in Fig. 4f demonstrate an almost linear increase in the estimation error with escalating levels of sensor noise. Notably, even under the most severe conditions at noise level 10, which substantially surpasses typical industry standards, the developed estimation model maintains an MAE of less than 16 mV. This finding underscores that the proposed lifelong estimation framework and its embedded Model 3 are capable of delivering accurate and robust performance in the presence of large sensor noise.

Table 4: Ten levels of Gaussian white noise introduced to measurements.

| Sensor noise level | 0 | 1 | 2 | 3 | 4 | 5 | 6 | 7 | 8 | 9 | 10 |
|---|---|---|---|---|---|---|---|---|---|---|---|
| Current (mA) | 0 | 5 | 10 | 15 | 20 | 25 | 30 | 35 | 40 | 45 | 50 |
| Voltage (mV) | 0 | 2.5 | 5 | 7.5 | 10 | 12.5 | 15 | 17.5 | 20 | 22.5 | 25 |
| Temperature (°C) | 0 | 0.5 | 1 | 1.5 | 2 | 2.5 | 3 | 3.5 | 4 | 4.5 | 5 |

*Computational efficiency*

The computational efficiency of the designed estimation algorithm, which integrates Models 1-3, is important for enabling optimal charging control in vehicle BMS. The computational load of the algorithm was assessed using a Nvidia Tesla A100 GPU in a Python environment. To reduce randomness in the evaluation, the algorithm is tested over ten times under identical conditions, with the mean computation times reported in Table 5.

Despite the extensive dataset used, the training process for all three developed models only requires 1060 seconds, while the testing process exhibits remarkable computational efficiency, completing in 5.27 seconds. The execution time for estimating the plating potential over a single real-world charging cycle is merely 0.16 seconds. Note that such calculations are conservative, as the three models can be executed in parallel to reduce the total required computation time. These results underscore the algorithm's high practicality for real-world battery management applications.

Table 5: Computation time required by the proposed estimation algorithm.

|  | Computation time (s) | | | Data size | | |
|---|---|---|---|---|---|---|
|  | Training | Testing | Single charge | Training | Testing | Single charge |
| Model 1 | 13 | 0.28 | 0.01 | 7552 | 1888 | 1 |
| Model 2 | 366 | 2.12 | 0.09 | $2.75 \times 10^7$ | $6.88 \times 10^6$ | 3645 |

(continued)

| | Computation time (s) | | | Data size | | |
|---|---|---|---|---|---|---|
| | Training | Testing | Single charge | Training | Testing | Single charge |
| Model 3 | 681 | 2.87 | 0.06 | $8.30 \times 10^6$ | $2.08 \times 10^6$ | 250 |
| Total | 1060 | 5.27 | 0.16 | | | |

*Conclusions*

This disclosure bridges a critical gap in EV technology by challenging the conventional compromise between the rapid charging of lithium-ion batteries and their longevity. Through rigorous experimental validation on three-electrode battery cells, a plating potential controlled charging strategy was established that not only permits a minimum of 30% faster charging rates but also significantly extends battery lifespan by preventing lithium plating, a notorious catalyst for premature battery degradation. To adopt these findings in commercial EV batteries without a reference electrode, this disclosure introduces a ground-breaking machine learning-based framework for estimating plating potential throughout the battery's life. This framework, leveraging a combination of real-time battery data, estimated information of SoH indicators, and sophisticated modelling techniques, ensures lifelong robust and accurate predictions under a variety of operating conditions. This work highlights the opportunity to double battery lifespan without compromising charging speed using ML techniques. The findings of this disclosure mark a pivotal advance toward the development of more efficient, durable, and user-friendly EV batteries.

*Implementation*

The battery anode potential estimation method is typically implemented in a computer or electronic control unit within the vehicle, or remotely in a stationary server solution that can establish a data communication channel with the vehicle.

Such a computer typically includes a computer program for real-time estimation of the anode potential of the battery in connection with a battery charging event, wherein the computer program comprises computer-readable instructions which, when executed by the computer, causes the computer to: obtain at least one quantified State of Health [SoH] indicator of the battery as output from a first machine-learning system, and feed the obtained at least one quantified SoH indicator, together with battery charging data associated with the charging event, as input to a second machine-learning system, which provides an estimate of the anode potential of the battery as output.

The disclosure also relates to a system for real-time estimation of the anode potential of the battery in connection with a battery charging event. The system may be implemented in a vehicle, such as in the BMS of the vehicle, or within another electronic controller of the vehicle, or remotely from the vehicle in a cloud solution.

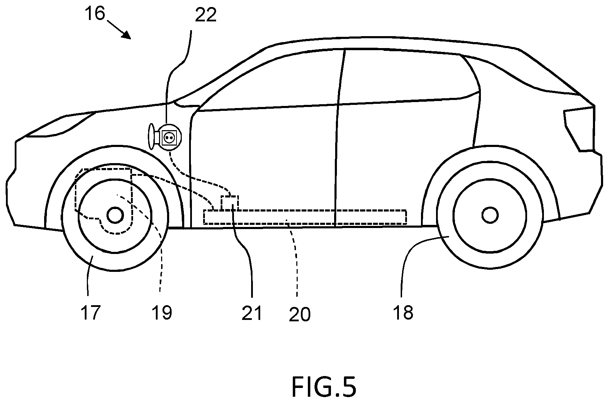

Figure 5 shows a vehicle 16, in particular a battery electric or hybrid electric vehicle 16, having front wheels 17, rear wheels 18, an electric motor 19 with integrated inverter, a high-voltage electric battery 20, a BMS 21 and a battery charging plug-in 22.

The system for real-time estimation of the anode potential of the battery comprises one or more processors configured to: obtain at least one quantified State of Health [SoH] indicator of the battery as output from a first machine-learning system; and feed the obtained at least one quantified SoH indicator, together with battery charging data associated with the charging event, as input to a second machine-learning system, which provides an estimate of the anode potential of the battery as output.

The one or more processors may be processors of the BMS, or of another electronic controller of the vehicle, or of a remote server of a cloud solution or the like.

*Experimental procedures*

*Data and code availability*

The raw cycling data for the three-electrode battery cells can be found at: (https://drive.google.com/file/d/1hkryupdtKwx4bfoolwDW0linKfkywi5c/view?usp=sharing)

The software code can be found at: (https://drive.google.com/drive/folders/1dRwM8bwEp7trW3pCKQNU9ZMTFO3m6hCA?u sp=sharing)

*Electrochemical battery modelling and simulation*

*SEI layer growth model*

The liquid electrolyte used in Li-ion battery cells becomes unstable and reacts with lithium ions and electrons within the electrodes to form a passive solid-electrolyte interface (SEI) during charging in the first cycle, leading to around 10% capacity loss. The SEI layer will continue to grow during battery usage, leading to capacity loss and resistance increase. There are several ways to model SEI growth. To describe the dynamics of the SEI growth, a kinetics-limited model developed in "Modelling of lithium plating induced aging of lithium-ion batteries: Transition from linear to nonlinear aging", J. Power Sources 360 (2017) 28-40, by X.-G. Yang, Y. Leng, G. Zhang, S. Ge, C.-Y. Wang, is adopted here, in which the exchange current density of the SEI-based side reactions is expressed in the Tafel equation:

$$i_{\mathrm{SEI}} = i_{0,\mathrm{SEI}} \exp\left(\frac{\alpha n F}{RT} \eta_{\mathrm{SEI}}\right), \tag{1}$$

$$\eta_{\mathrm{SEI}} = U_{\mathrm{NE}}^{\mathrm{ref}} + \eta_{\mathrm{NE}} - U_{\mathrm{SEI}}^{\mathrm{ref}}. \tag{2}$$

In (1), $i_{0,\mathrm{SEI}}$ is the reference exchange current density, $\alpha$ is a transfer coefficient, n is the number of electrons participating in the reaction, F is the Faraday's constant, R is the ideal gas constant, and T represents the battery temperature. In (2), $\eta_{\mathrm{SEI}}$ is the overpotential of the SEI-based side reaction, $U^{\mathrm{ref}}$ is the equilibrium anode potential which is evaluated as a function of the solid phase concentration at the surface of the particle, $\eta_{\mathrm{NE}}$ is the anode overpotential, and $U^{\mathrm{ref}}$ is the equilibrium potential of the SEI growth reaction, respectively.

*LAM model*

The continuous cycling of Li-ion batteries may cause electrode dissolution, particle cracking and detachment from the binding materials, resulting in LAM in both the negative and positive electrodes. The volume fraction of active materials in each electrode, denoted by $\varepsilon$, can be modelled by

$$\frac{\partial \epsilon}{\partial t} = \beta \left(\frac{\sigma_{h,\max} - \sigma_{h,\min}}{\sigma_{\mathrm{yield}}}\right)^m, \tag{3}$$

where $\sigma_{h,max}$ and $\sigma_{h,min}$ are the minimum and maximum hydraulic stress, respectively, depending on the particle radius and the average lithium concentration within the particle. The values of parameters $B$, $m$, and $\sigma_{\mathrm{yield}}$ are often fitted from experimental data.

*Physical parameters and simulation conditions*

The SPMe-aging battery model employed in the simulation was previously parameterized against LG M50T cylindrical battery cells in "Lithium-ion battery degradation: how to model it", Phys. Chem. Chem. Phys. 24 (13) (2022) 7909-7922, by S. E. O'Kane, W. Ai, G. Madabattula, D. Alonso-Alvarez, R. Timms, V. Sulzer, J. S. Edge, B. Wu, G. J. Offer, M. Marinescu. The parameter values from this reference were taken and a set of aging-rated parameters were gradually varied, such as i0,SEI in (1) and $\beta$ in (3), among different simulations.

Each cycle of the cell operation includes a CC-CV charge with a cut-off voltage of 4.2 V at the CC stage and a cut-off current of 50 mA at the CV stage, followed by a CC discharge with a cut-off voltage of 2.5 V. Between adjacent charge and discharge phases, a one-hour relaxation period is introduced to mimic battery behaviour under calendar aging. For comprehensive coverage of diverse operating conditions encountered in real-world scenarios, the simulation incorporates various charging current rates and ambient temperatures. The simulation process is terminated if the cell has reached its end of life. Every 50 cycles, an RPT is performed to get the pseudo-OCV measurement, in which the cell is charged and discharged at 1/10C until the cut-off voltage limit of 4.2 V is reached.

*ML-based battery modelling and implementation*

The methods for developing the three ML models in the proposed lifelong estimation framework are introduced in this subsection.

*KF-based fusion of ML models for capacity estimation*

The methods for online capacity estimation have been well-established in the literature. A data-driven multi-model fusion method was recently developed and demonstrated high accuracy and practicability under arbitrary vehicle usage conditions, as published in "State of health estimation for lithium-ion batteries under arbitrary usage using data-driven multi-model fusion", IEEE Trans. Transp. Electrif. (2023), by Y. Zhang, T. Wik, J. Bergström, C. Zou. This data-driven multi-model fusion method may be adopted in Model 1 to estimate battery capacity continuously over the lifespan. For details of said method, reference is made to said publication, while the key idea is introduced here for completeness: First, a tailored set of features is meticulously curated from time-series current, voltage, and temperature measurements during battery charging. Based on these features, four distinct ML algorithms, including two probabilistic and two frequentist approaches, are applied to estimate the battery capacity. Second, leveraging usage-related histogram data, a one-step-ahead capacity prediction model is developed. In the end, a Kalman filter (KF) is utilized to systematically fuse the results of all the estimation and prediction models.

*LSTM foraging mode quantification*

The cell OCV curve or electrochemical impedance spectroscopy (EIS) can potentially be obtained at each RPT test and used to achieve the targets of Model 2. However, for real-world EV applications, it is practically challenging to receive either reliable EIS measurements over a wide frequency range or OCV measurements over the full SoC window. In contrast, extracting a pseudo-OCV curve, e.g., during destination charging or overnight home charging, is comparatively straightforward. Thus, features from the partial charging events within an LTSM model were formulated to quantify the three aging modes as the output of Model 2.

Other than traditional neural networks (NNs) that take a single data point as the input and require manual construction of features, LSTM takes a sequence of data and performs the regression or classification without the need for feature selection and engineering. This characteristic makes LSTM well-suited for speech recognition, language translation, and robot control tasks. Considering battery applications, the collected data are usually in time series by nature. Consequently, it is suitable to use LSTM to build an estimation model. Compared to recurrent neural networks (RNNs), also designed to process time-series data, LSTM can effectively avoid vanishing gradient during training.

A typical LSTM unit consists of two internal cells, i.e., a memory cell $c_t$ and a hidden cell $h_t$, where $t$ represents the current time step. The memory cells can be viewed as the state that saves information over a long period of time. The hidden cell, together with the gating mechanism composed of three main gates (i.e., the input, forget, and output gates), controls the information flowing within the neural network. The detailed calculation process can be represented by the following equations:

$$f_t = \sigma(W_f x_t + U_f h_{t-1} + b_f), \qquad i_t = \sigma(W_i x_t + U_i h_{t-1} + b_i),$$

$$o_t = \sigma(W_o x_t + U_o h_{t-1} + b_o), \qquad \tilde{c}_t = \tanh(W_c x_t + U_c h_{t-1} + b_c),$$

$$c_t = f_t \odot c_{t-1} + i_t \odot \tilde{c}_t, \qquad h_t = o_t \odot \tanh(c_t),$$

where $x_t$ is the input vector, $i_t$, $f_t$, and $o_t$ are the activation vectors of the input, forget, and output gates, respectively, and $\tilde{c}_t$ is the memory cell's input activation vector. $W$ and $U$ represent the weight matrices for the input and hidden state, respectively, b is the bias term, and $\odot$ denotes the element-wise product.

*Alternative methods for SoH indicator estimation*

Alternatively to the above approaches, two other types of approaches can be utilized to estimate the four SoH indicators. The first type is to extend the LSTM model as described in passage *"LSTM foraging mode quantification"* above to include all four SoH indicators as outputs. The second type is to extract a relevant and appropriate feature set for each SoH indicator and use them for training point-to-point ML models, such as Gaussian process regression (GPR), Bayesian regression (BR), random forest regression (RFR), and NN. A systematic comparison between the proposed approach and its two benchmarks is conducted. In general, the proposed approach in Sections *"KF-based fusion of ML models for capacity estimation"* and *"LSTM foraging mode quantification"* above can provide the most accurate estimation results for all the indicators.

*UE-LSTM for plating potential estimation*

For fast charging control based on plating potential, it is crucial to have a small safety margin so that the plating potential will not enter the negative region. Consequently, it becomes imperative to prioritize models exhibiting a tendency towards underestimation rather than overestimation, particularly as the plating potential approaches zero. To achieve this, a novel algorithm is proposed, termed UE-LSTM, which employs a unique loss function J defined as follows:

$$J = \frac{1}{N} \sum_{i}^{N} J_1(i), \qquad (4)$$

$$J_1(i) = \begin{cases} w_1 J_2(i), & \text{if } y_i \geq \hat{y}_i \\ J_2(i), & \text{otherwise} \end{cases} \qquad (5)$$

$$J_2(i) = \begin{cases} w_2(y_i - \hat{y}_i)^2, & \text{if } |y_i| \leq 0.02 \\ (y_i - \hat{y}_i)^2, & \text{otherwise} \end{cases} \qquad (6)$$

where $y_i$ and $\hat{y}_i$, are the true and estimated plating potential values, respectively. (5) is designed with a weighting factor $w_1 = 10$ to favour scenarios of underestimation. (6) incorporates a large weighting factor $w_2 = 50$ to improve estimation accuracy within the plating potential range of [-0.02, 0.02] V.

*Training data labelling*

The capacity of the battery cell can either be directly measured during RPT tests or estimated using an accurate and reliable estimator, e.g., the one developed in the publication "State of health estimation for lithium-ion batteries under arbitrary usage using data-driven multi-model fusion", IEEE Trans. Transp. Electrif. (2023), by Y. Zhang, T. Wik, J. Bergström, C. Zou., which concerns a data-driven multi-model fusion method for SoH estimation under arbitrary usage profiles, wherein all possible operating conditions are categorized into six scenarios, and for each scenario, an appropriate feature set is extracted to indicate the SoH. Based on the obtained features, four machine learning algorithms are applied individually to train SoH estimation models using time-series data. In addition to the estimates at the current time step, a histogram data-based and online adaptive model is taken from previous work for predicting the next-step SoH. Then, a Kalman filter is applied to systematically fuse the results of all the estimation and prediction models.

As described in "Quantifying lithium lost to plating and formation of the solid-electrolyte interphase in graphite and commercial battery components", Appl. Mater. Today 28 (2022) 101527 by Y. Fang, A. J. Smith, R. W. Lindström, G. Lindbergh, I. Furo, there are established methods to experimentally extract LLI information through an advanced lab setting. It is however preferred to calculate the three aging modes continuously over the battery's life using pseudo-OCV measurements and the diagnostic algorithm as described in "Degradation diagnostics for lithium ion cells", J. Power Sources 341 (2017) 373-386, by C. R. Birkl, M. R. Roberts, E. McTurk, P. G. Bruce, D. A. Howey.

*Evaluation matrices*

The MAE and RMSE are used to quantify the estimation performance for the four considered SoH indicators.

These two evaluation matrices are defined as

$$MAE = \frac{1}{N} \sum_{i=1}^{N} (y_i - \hat{y}_i) \qquad (7)$$

$$RMSE = \sqrt{\frac{1}{N}\sum_{i=1}^{N}(y_i - \hat{y}_i)^2} \qquad (8)$$

where N represents the total number of samples in the test set, $y_i$ and $\hat{y}_i$, are the true value and the estimated value, respectively, and i is the time step. For the plating potential estimation, in addition to the MAE and RMSE, the coefficient of determination is used to evaluate how well the model fits the test samples, as defined by

$$R_2 = 1 - \frac{\sum_{i=1}^{N}(y_i - \hat{y}_i)^2}{\sum_{i=1}^{N}(y_i - \bar{y})^2}, \qquad (9)$$

where the average estimated value $\bar{y} = \frac{1}{N}\sum_{i=1}^{N}\hat{y}_i$.

The present disclosure has been presented above with reference to specific embodiments. However, other embodiments than the above described are possible and within the scope of the disclosure. Different method steps than those described above, performing the method by hardware or software, may be provided within the scope of the disclosure.

The methods disclosed herein may be implemented in a general purpose computer, a processor, or a processor core. Suitable processors include, by way of example, a general purpose processor, a special purpose processor, a conventional processor, a digital signal processor (DSP), a plurality of microprocessors, one or more microprocessors in association with a DSP core, a controller, a microcontroller, Application Specific Integrated Circuits (ASICs), Field Programmable Gate Arrays (FPGAs) circuits, any other type of integrated circuit (IC), and/or a state machine.

The methods or flow charts provided herein may be implemented in a computer program, software, or firmware incorporated in a computer-readable storage medium for execution by a general purpose computer or a processor. Examples of computer-readable storage mediums include a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs).

The processor(s) associated with the system of the present disclosure may be or include any number of hardware components for conducting data or signal processing or for executing computer code stored in memory. The system may have an associated memory, and the memory may be one or more devices for storing data and/or computer code for completing or facilitating the various methods described in the present description. The memory may include volatile memory or non-volatile memory. The memory may include database components, object code components, script components, or any other type of information structure for supporting the various activities of the present description. According to an exemplary embodiment, any distributed or local memory device may be utilized with the systems and methods of this description. According to an exemplary embodiment the memory is communicably connected to the processor (e.g., via a circuit or any other wired, wireless, or network connection) and includes computer code for executing one or more processes described herein.

It will be appreciated that the above description is merely exemplary in nature and is not intended to limit the present disclosure, its application or uses. While specific examples have been described in the specification and illustrated in the drawings, it will be understood by those of ordinary skill in the art that various changes may be made and equivalents may be substituted for elements thereof without departing from the scope of the present disclosure as defined in the claims. Furthermore, modifications may be made to adapt a particular situation or material to the teachings of the present disclosure without departing from the essential scope thereof.

Therefore, it is intended that the present disclosure not be limited to the particular examples illustrated by the drawings and described in the specification as the best mode presently contemplated for carrying out the teachings of the present disclosure, but that the scope of the present disclosure will include any embodiments falling within the foregoing description and the appended claims. Reference signs mentioned in the claims should not be seen as limiting the extent of the matter protected by the claims, and their sole function is to make claims easier to understand.

REFERENCE SIGNS

1. EL-cell three-electrode cell holder
2. Battery cell

3. Synthetic data generation
4. RTP profile
5. Fast charging profile
6. Machine learning Model 1 for capacity estimation
7. Machine learning Model 2 for Aging modes quantification
8. Quantified SoH indicators
9. Data collection during online deployment, with online measurement of battery parameters
10. Destination charging (slow charging)
11. Fast charging
12. Machine learning Model 3 for lifelong anode potential estimation
13. Estimated battery anode potential
14. First machine learning system
15. Second machine learning system
16. Battery electric or hybrid electric vehicle
17. Front wheel
18. Rear wheel
19. Electric motor with integrated inverter
20. High-voltage electric battery
21. BMS
22. Battery charging plug-in

**Claims**

1. A method for real-time estimation of an anode potential of a battery (20) in connection with a battery charging event, comprising:

   obtaining at least one quantified State of Health [SoH] indicator of the battery (20) as output from a first machine-learning system (14), and
   feeding the obtained at least one quantified SoH indicator, together with battery charging data associated with the charging event, as input to a second machine-learning system (15), which provides an estimate of the anode potential of the battery (20) as output.

2. The method according to claim 1:
   wherein the first machine-learning system (14), in connection with a charging events, frequently updates the at least one quantified SoH indicator based on battery charging data obtained from said charging events.

3. The method according to claim 2:
   wherein the first machine-learning system (14) primarily or only updates the at least one quantified SoH indicator based on battery charging data obtained from charging events that are **characterised by** slow charging speed.

4. The method according to any of the preceding claims, wherein the second machine-learning system (15) primarily or only estimates the anode potential of the battery (20) based on battery charging data obtained from charging events that are **characterised by** fast charging speed.

5. The method according to any of the preceding claims, wherein the at least one SoH indicator obtained as output from the first machine-learning system (14) includes battery capacity as a first SoH indicator, and at least a first aging mode as a second SoH indicator.

6. The method according to claim 5, wherein the at least one SoH indicator obtained as output from the first machine-learning system (14) additionally includes a second aging mode as a third SoH indicator, specifically also a third aging mode as a fourth SoH indicator.

7. The method according to any of the preceding claims 5 to 6,

   wherein the first aging mode is any of lithium inventory loss (LLI), loss of active materials in the negative electrode ($LAM_{NE}$), and loss of active material in the positive electrode ($LAM_{PE}$), or
   wherein the first and second aging modes are any of lithium inventory loss (LLI), loss of active materials in the negative electrode ($LAM_{NE}$), and loss of active material in the positive electrode ($LAM_{PE}$), or
wherein the first, second and third aging modes are lithium inventory loss (LLI), loss of active materials in the negative electrode ($LAM_{NE}$), and loss of active material in the positive electrode ($LAM_{PE}$).

8. The method according to any of the preceding claims 5 to 7, wherein the at least one SoH indicator obtained as output from the first machine-learning system (14) includes battery capacity as a first SoH indicator and at least a first aging mode as a second SoH indicator,

   wherein the first machine-learning system comprises a first machine learning model for estimating the battery capacity and a second machine learning model for estimating the first aging mode, or
   wherein the first machine-learning system comprises a single machine learning model for estimating both the battery capacity and the first aging mode.

9. The method according to any of the preceding claims 6 to 8, wherein the at least one SoH indicator obtained as output from the first machine-learning system (14) includes battery capacity as a first SoH indicator, a first aging mode as a second SoH indicator, a second aging mode as a third SoH indicator, specifically also a third aging mode as a fourth SoH indicator,

   wherein the first machine-learning system comprises a first machine learning model for estimating the battery capacity and a second machine learning model for estimating all the aging modes, or
   wherein the first machine-learning system comprises a single machine learning model for estimating both the battery capacity and all the aging modes, or
   wherein the first machine-learning system comprises an individual machine learning model, such as Gaussian process regression (GPR), Bayesian regression (BR), random forest regression (RFR), or Neural Network (NN), for estimating each SoH indicator separately.

10. The method according to any of the preceding claims, wherein the second machine-learning system (15) is implemented as a long short-term memory network (LSTM) machine learning algorithm, an underestimate-enhanced long short-term memory (UE- LSTM) machine learning algorithm, or a neural network, specifically a gated recurrent unit (GRU) neural network or an artificial neural network (ANN).

11. The method according to any of the preceding claims, wherein the battery charging data includes charging current, charging voltage, and battery charging temperature.

12. The method according to any of the preceding claims,

    wherein the first machine-learning system (14) is trained based on battery charging data obtained from charging cycles **characterised by** a slow charging speed; and/or
    wherein the second machine-learning system (15) is trained based on battery charging data obtained from charging cycles **characterised by** fast charging speed.

13. A method for performing fast charging of a battery (20) while reducing the risk for lithium plating, comprising:

    controlling the charging current such that a battery anode potential is above a threshold value, wherein the battery anode potential is estimated according to the method of any of claims 1 to 12.

14. A computer program for real-time estimation of an anode potential of a battery (20) in connection with a battery charging event, the computer program comprises a computer-readable instructions which, when executed by a computer, causes the computer to:

    obtain at least one quantified State of Health [SoH] indicator of the battery (20) as output from a first machine-learning system (14), and
    feed the obtained at least one quantified SoH indicator, together with battery charging data associated with the charging event, as input to a second machine-learning system (15), which provides an estimate of the anode potential of the battery (20) as output.

15. A system for real-time estimation of an anode potential of a battery (20) in connection with a battery charging event, the system comprising one or more processors configured to:

obtain at least one quantified State of Health [SoH] indicator of the battery (20) as output from a first machine-learning system (14), and

feed the obtained at least one quantified SoH indicator, together with battery charging data associated with the charging event, as input to a second machine-learning system (15), which provides an estimate of the anode potential of the battery (20) as output.

FIG.1a

FIG.1b

FIG.1c

FIG.1d

(e)

FIG.1e

FIG.2

FIG.3a

FIG.3b

(a)

FIG.4a

(b)

FIG.4b

FIG.4c

FIG.4d

FIG.4e

FIG.4f

FIG.5

Europäisches
Patentamt

European
Patent Office

Office européen
des brevets

## EUROPEAN SEARCH REPORT

**Application Number**

EP 24 17 0319

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/059529 A1 (BAUMANN MICHAEL [DE]) 23 February 2023 (2023-02-23) * abstract; figures 1-9 * * paragraphs [0003] - [0011], [0031], [0049] - [0057], [0080] - [0081] * ----- | 1-15 | INV. G01R31/367 G01R31/392 G06N3/044 G06N3/045 G06N3/08 H01M10/44 |
| Y | DE 10 2020 117609 A1 (TWAICE TECH GMBH [DE]) 5 January 2022 (2022-01-05) * abstract; figures 1-13 * * paragraphs [0009] - [0025], [0033] - [0049] * ----- | 1-15 | |

TECHNICAL FIELDS
SEARCHED (IPC)

G01R
G06N
H01M

The present search report has been drawn up for all claims

| Place of search | Date of completion of the search | Examiner |
|---|---|---|
| Munich | 1 October 2024 | Kleiber, Michael |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

**EP 4 636 417 A1**

## ANNEX TO THE EUROPEAN SEARCH REPORT
## ON EUROPEAN PATENT APPLICATION NO.

EP 24 17 0319

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2024

| Patent document cited in search report | Publication date | Patent family member(s) | Publication date |
|---|---|---|---|
| US 2023059529 A1 | 23-02-2023 | DE 102020100668 A1 | 15-07-2021 |
| | | EP 4090986 A1 | 23-11-2022 |
| | | US 2023059529 A1 | 23-02-2023 |
| | | WO 2021143983 A1 | 22-07-2021 |
| DE 102020117609 A1 | 05-01-2022 | DE 102020117609 A1 | 05-01-2022 |
| | | US 2024010100 A1 | 11-01-2024 |
| | | WO 2022003208 A1 | 06-01-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J. S. EDGE ; S. O'KANE ; R. PROSSER ; N. D. KIRKALDY ; A. N. PATEL ; A. HALES ; A. GHOSH ; W. AI ; J. CHEN ; J. YANG et al.** Lithium ion battery degradation: what you need to know. *Phys. Chem. Chem. Phys.*, 2021, vol. 23 (14), 8200-8221
- **S. J. MOURA ; F. B. ARGOMEDO ; R. KLEIN ; A. MIRTABATABAEI ; M. KRSTIC**. Battery state estimation for a single particle model with electrolyte dynamics. *IEEE Trans. Control Syst. Technol.*, 2016, vol. 25 (2), 453-468
- **S. E. O'KANE ; W. AI ; G. MADABATTULA ; D. ALONSO-ALVAREZ ; R. TIMMS ; V. SULZER ; J. S. EDGE ; B. WU ; G. J. OFFER ; M. MARINESCU**. Lithium-ion battery degradation: how to model it. *Phys. Chem. Chem. Phys.*, 2022, vol. 24 (13), 7909-7922
- **X.-G. YANG ; Y. LENG ; G. ZHANG ; S. GE ; C.-Y. WANG**. Modelling of lithium plating induced aging of lithium-ion batteries: Transition from linear to nonlinear aging. *J. Power Sources*, 2017, vol. 360, 28-40
- **Y. ZHANG ; T. WIK ; J. BERGSTRÖM ; C. ZOU**. State of health estimation for lithium-ion batteries under arbitrary usage using data-driven multi-model fusion. *IEEE Trans. Transp. Electrif.*, 2023
- **Y. FANG ; A. J. SMITH ; R. W. LINDSTRÖM ; G. LINDBERGH ; I. FURO**. Quantifying lithium lost to plating and formation of the solid-electrolyte interphase in graphite and commercial battery components. *Appl. Mater. Today*, 2022, vol. 28, 101527
- **C. R. BIRKL ; M. R. ROBERTS ; E. MCTURK ; P. G. BRUCE ; D. A. HOWEY**. Degradation diagnostics for lithium ion cells. *J. Power Sources*, 2017, vol. 341, 373-386